Europäisches Patentamt

European Patent Office

Office européen des brevets

(11) Veröffentlichungsnummer: **0 087 025**
A2

(12) **EUROPÄISCHE PATENTANMELDUNG**

(21) Anmeldenummer: 83101042.6

(22) Anmeldetag: 04.02.83

(51) Int. Cl.³: **G 01 R 25/08**
G 01 R 25/00, G 01 R 23/10
G 01 P 3/56

(30) Priorität: 15.02.82 DE 3205240

(43) Veröffentlichungstag der Anmeldung:
31.08.83 Patentblatt 83/35

(84) Benannte Vertragsstaaten:
AT BE CH DE FR GB IT LI LU NL SE

(71) Anmelder: Forschungsgesellschaft Druckmaschinen e.V.
Lyonerstrasse 18
D-6000 Frankfurt(DE)

(72) Erfinder: Spiegel, Nikolaus
Zeilharder Strasse 14a
D-6107 Reinheim 4(DE)

(72) Erfinder: Fischer, Rudolf
Dieburger Strasse 75
D-6100 Darmstadt(DE)

(74) Vertreter: Stoltenberg, Baldo Heinz-Herbert
c/o Heidelberger Druckmaschinen AG
Kurfürsten-Anlage 52-60
D-6900 Heidelberg 1(DE)

(54) Verfahren und Vorrichtung zur hochgenauen Messung der Phasenlage bzw. Phasenverschiebung zweier Impulsfolgen.

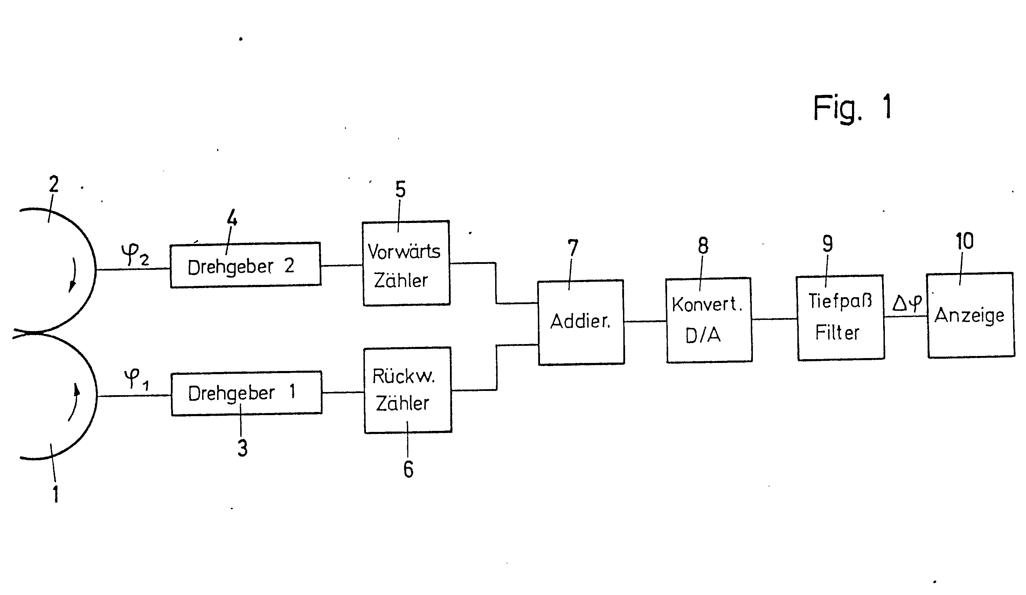

(57) Die Erfindung bezieht sich auf eine Vorrichtung und ein Verfahren zur hochgenauen Messung der Phasenlage bzw. Phasenverschiebung zweier Impulsfolgen unabhängig von der Impulsfrequenz. Hierzu werden die Drehwinkel zweier Rotationskörper 1 und 2 quantisiert, durch inkrementale Drehgeber 3 und 4 in Impulsfolgen umgewandelt, und diese anschließend in zumindest zwei differenten Digitalzähler 5 und 6 erfaßt (Figure 1). Das aus einer nachfolgenden digitalen Differenzbildung der beiden Zählerstände in einem Addierer 7 gebildete digitale Differenzergebnis wird in einem Digital/Analog-Konverter 8 gewandelt und durch Dekodierung in einem Tiefpaßfiler 9 zu einem kontinuierlichen, analogen Signal des Differenzdrehwinkels $\Delta\varphi$ umgeformt, welches einer Anzeigevorrichtung 10 zugeführt wird. Zur Weiterverarbeitung des $\Delta\varphi$-proportionalen Analogsignales zur Bestimmung der Differenzwinkelgeschwindigkeit oder des pro Umdrehung, pro Winkel, bzw. pro Zeiteinheit aufgelaufenen Differenzdrehwinkels ist zwischen dem Tiefpaßfilter 9 und der Anzeigevorrichtung 10 zusätzlich ein taktgesteuertes Speicherglied 30 zwischengeschaltet. Die Taktung kann mittels der Drehgeber 3 und 4, der Digitalzähler 5 und 6 oder mittels Vorgabe eines Zeittaktes durch ein separates Zeitglied 31 erfolgen. Durch Vorschaltung eines Frequenzzählers 32 vor die Anzeigevorrichtung 10 ist außerdem eine Frequenzbestimmung möglich.

Fig. 1

- 1 -

Die Erfindung betrifft ein Verfahren und eine Vorrichtung zur hochgenauen Messung der Phasenlage bzw. Phasenverschiebung zweier Impulsfolgen, bei dem beispielsweise die Drehwinkel zweier Rotationskörper quantisiert, durch inkrementale Drehgeber in Impulsfolgen umgewandelt und diese zur Ermittlung der Phasenlage bzw. der Phasenverschiebung herangezogen werden.

Die Voraussetzung für den gleichmäßigen Lauf eines Zahnrad- bzw. Reibradgetriebes ist ein konstantes Verhältnis der Winkelgeschwindigkeiten zwischen den Rädern der einzelnen Radpaarungen. Sobald zwischen treibendem und getriebenem Rad Geschwindigkeitsdifferenzen auftreten, wird der Gleichlauf beeinträchtigt; unerwünschte Übersetzungsfehler sind die Folge.

So sind z.B. bei Offsetdruckmaschinen, unabhängig von deren Konstruktionsprinzip, generell die Antriebsverhältnisse deren Zylinder (Platten-, Gummi- und Gegendruckzylinder) mehrfach statisch überbestimmt. Da die Zylinder sowohl formschlüssig durch Zahnräder (Stirnräder) als auch reibschlüssig durch Schmitzringe sowie außerdem durch den Kontakt zwischen Druckplatte und Gummizylinder angetrieben werden, besteht ein Offsetdruckwerk aus mehreren dreifach überbestimmten Zweizylinder-Systemen. Da der formschlüssige Antrieb über die Zahnräder die Gleichheit der Drehzahl der Zylinder erzwingt, kann ein derartiges System nur dann funktionieren, wenn als Ausgleichsmechanismus ein Schlupf zwischen den den Kraftschluß bewirkenden Kontaktzonen auftritt, was wiederum zu Relativbewegungen in den farbübertragenen Zonen führt, welche Druckstörungen und Qualitätsminderungen verschiedenster Art verursachen können. Zur Beurteilung der Wirkung jeweils eines einzelnen Antriebes muß dessen Übersetzung, vollkommen unabhängig von weiteren vorhandenen Antrieben, möglichst genau ermittelt werden.

Hierzu ist es bekannt, an den Zapfen zweier zusammenwirkender benachbarter Zylinder eines Druckwerkes inkrementale Drehgeber anzubringen, die in Abhängigkeit von ihrer Teilung gemäß der Anzahl N der Inkremente auf ihrer Codierscheibe eine entsprechende Anzahl von Impulsen pro Zylinderumdrehung liefern, wodurch der Drehwinkel quantisiert wird. Von Quantisierung zu Quantisierung bzw. von Impuls zu Impuls wird dabei ein Winkel $\varphi_Q$ von 360°/N überstrichen. Während der Rotation der beiden Zylinder liefern die Ausgänge der Drehgeber zwei Impulsfolgen, die einerseits die Information bezüglich der momentanen Winkelgeschwindigkeit der einzelnen Zylinder, andererseits aber auch die Information über deren Differenzwinkelgeschwindigkeit enthalten. Zur exakten Bestimmung der Übersetzung wird eine Quotientenbildung zwischen der Differenzwinkelgeschwindigkeit und der Winkelgeschwindigkeit des treibenden Zylinders vorgenommen. Nach Elimination der Zeit stellt das Signal den vom anfänglichen Bezugspegel in einer bestimmten Zeitspanne aufgelaufenen Differenzdrehwinkel $\Delta\varphi$ - bezogen auf den zurückgelegten Winkel des treibenden Zylinders - dar.

Die Größe dieses Differenzdrehwinkels pro Umdrehung $\frac{\Delta\varphi}{u}$ hängt dabei von der jeweiligen Antriebsart ab. Bei formschlüssigem Antrieb mit einer Übersetzung der Verzahnung von $i = 1$ ist der Differenzdrehwinkel langfristig Null, kurzfristig schwankt er entsprechend dem vorhandenen Verzahnungsfehler um Null. An Druckmaschinenantrieben vorgenommene genaue Messungen haben ergeben, daß der auftretende Differenzdrehwinkel $\frac{\Delta\varphi}{\mu} \leq |10^{-4}|$ beträgt und somit meist innerhalb einer Quantisierungsstufe (N = 10.000 Impulse) liegt. Bei reibschlüssigem Antrieb über die Schmitzringe kann sowohl der momentane wie auch der langfristige Differenzdrehwinkel innerhalb einer Quantisierungsstufe liegen. Die durch Fertigungstoleranzen bedingten, unterschiedlichen Umfänge der Schmitzringe bewirken eine langsame Zunahme des Differenzdrehwinkels in die eine oder andere Richtung, weshalb -will man zu einem annähernd exakten Ergebnis gelangen - die Genauigkeit der Messung über mehrere Quantisierungsstufen hinweg erhalten bleiben muß. Bei reibschlüssigem Antrieb über ein Gummituch liegt der Differenzdrehwinkel pro Umdrehung um zwei Zehnerpotenzen höher $(\frac{\Delta\varphi}{u} \leq |10^{-2}|)$ als bei formschlüssigem Antrieb, wobei die langsame Zunahme zusätzlich einen über mehrere hundert Quantisierungsstufen reichenden Meßbereich erfordert.

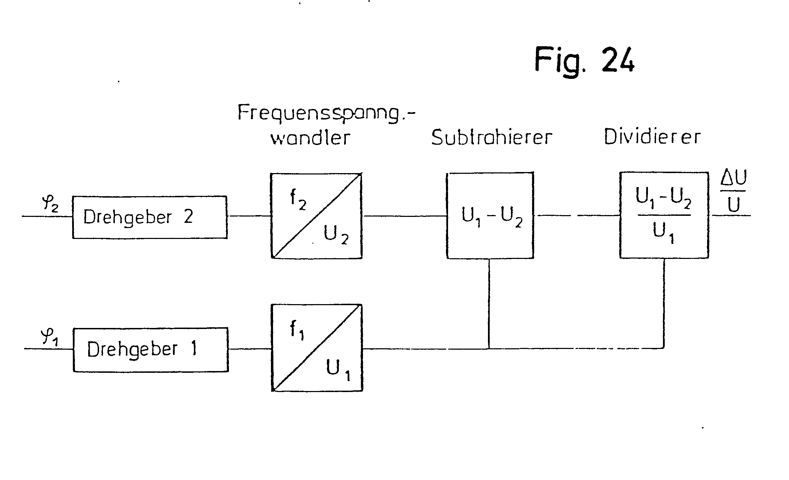

Bei einem anderen bekannten Meßverfahren werden beispielsweise die beiden Impulsfolgen, d.h. die beiden Frequenzen mittels Frequenzspannungswandler in Spannungen umgewandelt und danach in einem Subtrahierer die Differenz zwischen den beiden Spannungswerten erzeugt. In einem nachgeschalteten Dividierer wird eine Quotientenbildung zwischen der ermittelten Spannungsdifferenz und einer Bezugsspannung vorgenommen, welche von einem der beiden Frequenzspannungswandler erzeugt wird. Da die verarbeiteten Spannungen Frequenzen entsprechen, liefert das Ausgangssignal nur die zeitliche Änderung des Differenzdrehwinkels $\frac{\Delta\dot{\varphi}}{\varphi} = \frac{\Delta\omega}{\omega}$. Von Nachteil ist dabei, daß die Berechnung von $\frac{\Delta\varphi}{\varphi}$ nur durch eine aufwendige Integration des analogen Signals möglich ist, ohne die eine konkrete Aussage über die momentane Winkellage der Zylinder gegenüber einem Ausgangszustand nicht möglich ist. Bei Untersuchungen nahe dem Gleichlauf, d.h. beim Auftreten geringer Differenzdrehwinkel $(\frac{\Delta\varphi}{\mu} < |10^{-2}|)$, versagt dieses Verfahren vollständig, da die von den Frequenzspannungswandlern erzeugten Spannungen $U_1$ und $U_2$ in diesem Fall fast gleich groß sind und die Differenz der beiden nahezu Null ist. Ausgehend davon, daß die Frequenzspannungswandler systembedingt eine gewisse Restwelligkeit mit der Periode der umgesetzten Frequenz im Spannungssignal aufweisen, die größer ist als der absolute Meßwert, wird das Ausgangssignal nur noch durch diese Störung bestimmt, weshalb ein Nutzsignal selbst nicht mehr erkennbar ist.(Fig. 24)

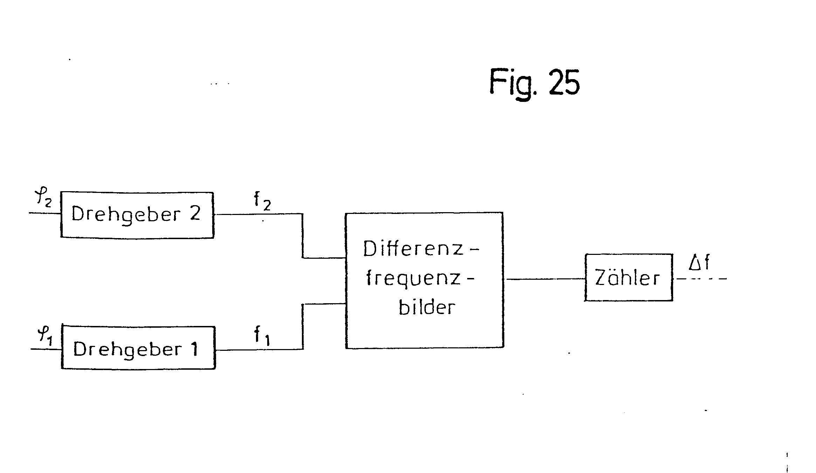

Ein in der Zeitschrift "Messen, Steuern, Regeln" 2/1981 auf den Seiten 98 bis 102 abgehandeltes neues Schlupfmeßverfahren für die Antriebstechnik benutzt ebenfalls zwei, beispielsweise von inkrementalen, rotatorischen Gebern erzeugte Impulsfolgen bestimmter Frequenz. Mittels eines digitalen Mischers wird aus diesen beiden Impulsfrequenzen die Differenzfrequenz gebildet, welche direkt proportional ist der Differenzwinkelgeschwindigkeit $\Delta\dot{\varphi} = \Delta\omega$. Im Gegensatz zum zuvor beschriebenen Meßverfahren beinhaltet die Differenzfrequenz keine Vorzeicheninformation, so daß nicht festgestellt werden kann, ob eine vorhandene Übersetzung ins Schnelle oder ins Langsame geht. Ein weiterer Nachteil dieses Verfahrens besteht darin, daß die Richtungstendenz eines vorhandenen Differenzdrehwinkels überhaupt nicht und dessen absolute Größe nur mittels aufwendiger Integration feststellbar ist. Bei einem Differenzdrehwinkel von $\frac{\Delta\varphi}{\mu} \leq |10^{-4}|$ wird die Periode der Differenzfrequenz derart lang, daß eine Information erst nach einer oder mehreren Zylinderumdrehungen zur Verfügung steht. (Fig. 25)

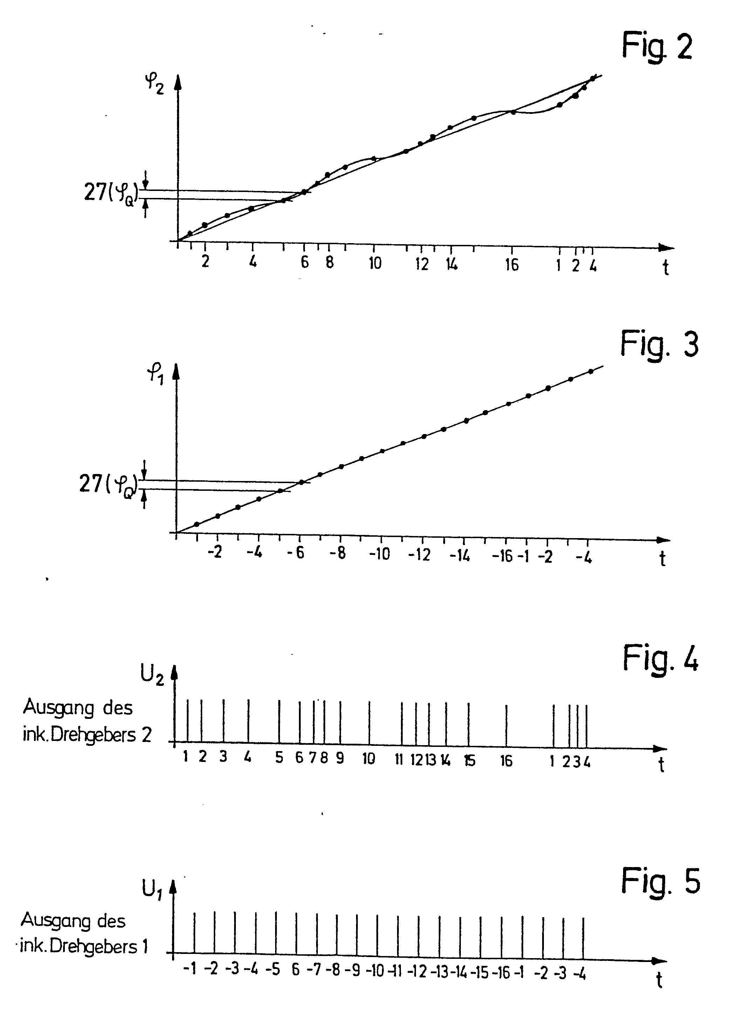

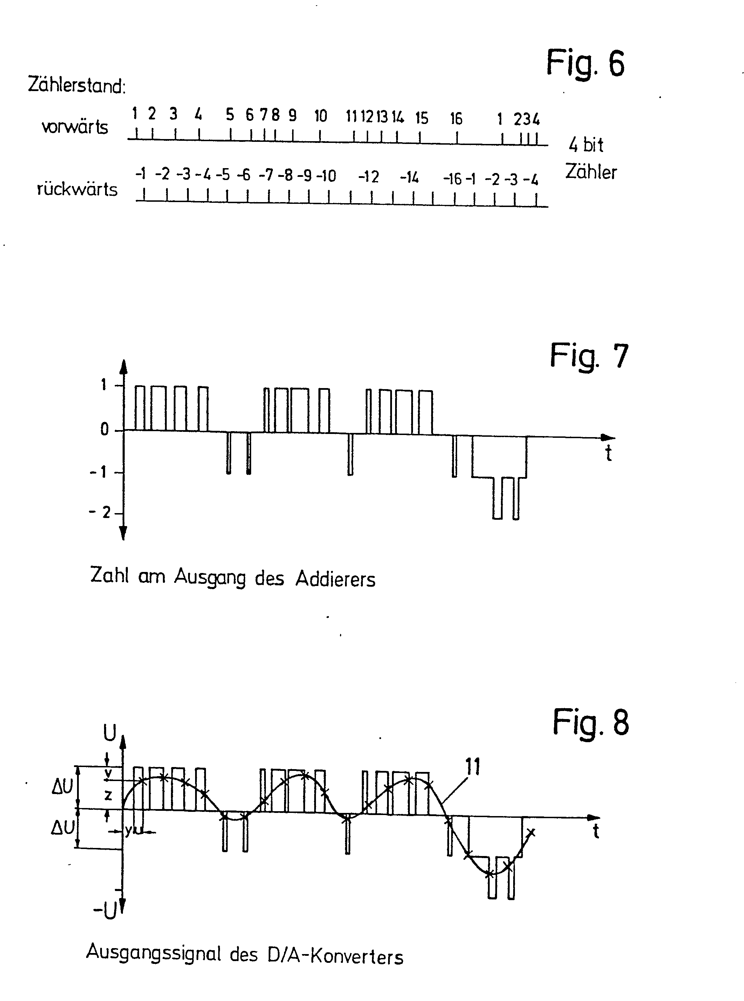

Die in der Abhandlung vorgeschlagene PLL-Regelschaltung, d.h. Vervielfachung der Differenzfrequenz, vermag hier keine Abhilfe zu schaffen, da deren Einschwingzeit ebenfalls mindestens eine Periode der Differenzfrequenz beträgt. Eine Vervielfachung der beiden Drehgeberimpulsfrequenzen vor dem Differenzfrequenzbilder, wie in den Figuren 2 und 6 der Abhandlung dargestellt, bringt zwar einerseits eine Erhöhung der resultierenden Differenzfrequenz, andererseits jedoch den Nachteil sehr hoher Impulsfrequenzen mit sich, da die Vervielfachung um den Faktor der Erhöhung vorgenommen werden muß. Diese hohen Impulsfrequenzen erreichen sehr schnell die Grenzfrequenz der elektronischen Bauteile, was zwangsweise eine Begrenzung der Drehzahl bedeutet.

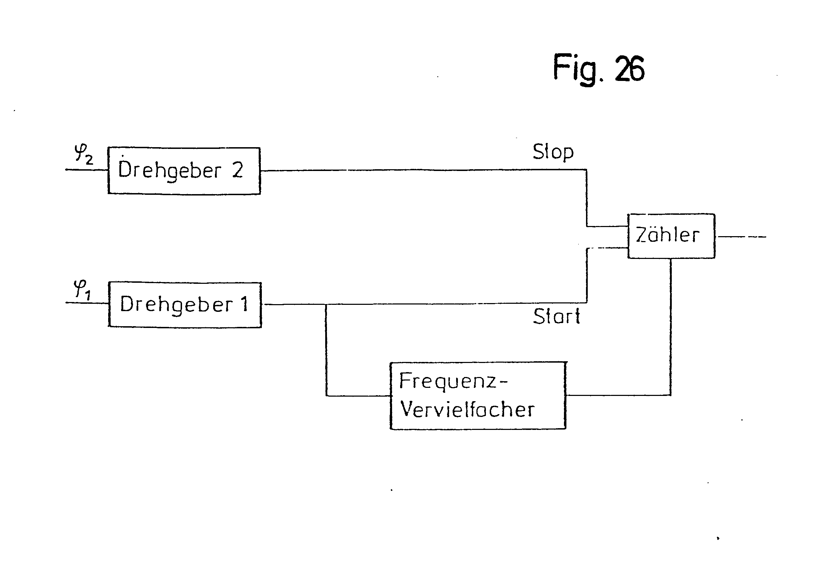

Ein weiteres, in VDI-Z 122, Nr. 1/2, 1980 beschriebenes Verfahren wird in Geräten zur Einflankenwälzprüfung von Zahnrädern benutzt. Hierbei werden die Impulse zweier Drehgeber zur Steuerung einer elektronischen Torschaltung verwendet, wobei die Impulse des ersten Drehgebers das Tor öffnen und mit den jeweils nachfolgenden Impulsen des zweiten Drehgebers dasselbe wieder geschlossen wird. Während der Toröffnungszeit wird eine Zahlimpulsfolge, die beispielsweise durch Frequenzvervielfachung aus einem der beiden Drehgeber gewonnen wurde, durchgelassen, wobei die durchgelassene Anzahl der Impulse proportional dem zwischen den Zylindern vorhandenen Differenzdrehwinkel ist. Da dies jedoch nur innerhalb einer Quantisierungsstufe gilt, kann der Differenzdrehwinkel $\Delta\varphi$, sobald er größer als eine Quantisierungsstufe wird, nur durch eine komplexe und daher sehr aufwendige Rechnerauswertung gewonnen werden. Die Auflösung ist direkt proportional zum gewählten Vervielfachungsfaktor. Bei Zunahme der Drehzahl erreicht jedoch die generierte Frequenz - genau wie beim zuvor beschriebenen Verfahren - schon im niedrigen Drehzahlbereich die Grenzfrequenz der elektronischen Bauteile.(Fig. 26)

Ausgehend von diesem Stand der Technik besteht die Aufgabe der Erfindung darin, ein Meßverfahren und eine Vorrichtung zur Durchführung desselben zu schaffen, mit denen sich die Phasenlage zweier vorzugsweise aus der Rotation zweier Rotationskörper gewonnener Impulsfolgen bzw. deren Phasenverschiebung sowohl innerhalb einer Quantisierung als auch über viele Quantisierungsstufen der Impulsgeber hinweg, unabhängig von der Impulsfrequenz bzw. der Drehzahl der Rotationskörper, mit absolut gleicher Genauigkeit exakt feststellen und in leicht weiterverarbeitbarer Form, vorzugsweise als Differenzdrehwinkel, anzeigen läßt.

Erfindungsgemäß wird diese Aufgabe bei einem Verfahren der eingangs genannten Gattung gelöst durch folgende Verfahrensschritte:

1. Zählung der Impulsfolgen in zumindest zwei differenten Zählern,

2. Digitale Differenzbildung der beiden Zählerstände und anschließende

3. Wandlung des digitalen Differenzergebnisses in ein Analogsignal,

4. Dekodierung des Analogsignales und

5. Anzeige des dekodierten Analogsignales.

Mit dieser Grundausführung des $\Delta\varphi$ -Meßverfahrens ist es möglich, den Differenzdrehwinkel $\Delta\varphi$ erheblich feiner als eine Quantisierung aufzulösen, trotzdem $\Delta\varphi$ bei dieser Auflösung über mehrere Quantisierungen hinweg mit absolut gleicher Genauigkeit gemessen werden kann, wobei jedoch auch bei unzulässig niedrigen Frequenzen das Verfahren im ungünstigsten Fall immerhin noch mit der Genauigkeit der Quantisierung arbeitet. Darüber hinaus ist die Genauigkeit des Meßverfahrens unabhängig von der Höhe der Impulsfolgefrequenz. Das Vorzeichen des Differenzdrehwinkels $\Delta\varphi$ ist durch das Vorzeichen des dekodierten Analogsignales außerdem von alleine gegeben.

In weiterer Ausgestaltung des erfindungsgemäßen Verfahrens werden die Zählerkapazitäten entsprechend des auftretenden Phasenwinkels $\Delta\varphi$ begrenzt und eine digitale Differenzbildung der beiden Zählerstände des Vorzählers und/oder des Überlaufzählers mit gleichzeitiger Wandlung des digitalen Differenzergebnisses in ein Analogsignal vorgenommen. Dieses Verfahren ist mit einfachen und billigen Bausteinen zu realisieren ohne dabei an Meßgenauigkeit einzubüßen und kommt in vorteilhafter Weise insbesondere dann zur Anwendung, wenn der Differenzdrehwinkel $\Delta\varphi$ innerhalb eines festen, bekannten Bereiches schwankt, und gleichzeitig die Impulsfolgefrequenzen sehr hoch sind.

Zwecks vorteilhafter Verarbeitung des $\Delta\varphi$ proportionalen Analogsignales, z.B. zur Bestimmung der Übersetzung von Antrieben oder zur Gleichlaufkontrolle zweier Antriebe besteht eine zusätzliche Ausgestaltung der $\Delta\varphi$ -Meßverfahren in folgenden Verfahrensschritten:

1. Erzeugung eines Abtastintervalles

2. Vorgabe und Speicherung des Abtastintervalles

3. Null-Setzung des Phasenwinkels zu Beginn des Abtastintervalles

4. Speicherung des während des Abtastintervalles aufgelaufenen Phasenwinkels

5. Erneute Null-Setzung des Phasenwinkels nach Ablauf des Abtastintervalles

6. Anzeige des gespeicherten Phasenwinkels $\Delta\Psi$ pro Abtastintervall.

Bei einem weiteren Zusatzmeßverfahren, das sich insbesondere zur Ermittlung der der Differenzwinkelgeschwindigkeit proportionalen Differenzfrequenz der Impulsfolgen eignet, wenn die Richtung der Differenzwinkelgeschwindigkeit systembedingt vorgegeben ist, wird das zur Anzeige vorgesehene, dem Differenzdrehwinkel $\Delta\Psi$ proportionale Analogsignal zur Frequenzbestimmung herangezogen.

Weitere vorteilhafte Ausgestaltungen des Erfindungsgedankens und sich daraus ergebene Vorteile sind in der nachfolgenden Beschreibung sowie in den Ansprüchen 3 bis 5, 7 bis 9 und 11 bis 26 enthalten.

Die Erfindung ist nachfolgend anhand eines in den Zeichnungen dargestellten $\Delta\Psi$-Grundmeßverfahrens, eines modifizierten $\Delta\Psi$-Grundmeßverfahrens sowie zweier Zusatzmeßverfahren näher erläutert.

Es zeigt:

Fig. 1         Den schematischen Aufbau einer Meßvorrichtung zur Durchführung des $\Delta\Psi$-Grundmeßverfahrens,

Fig. 2 bis 8   die Signalzustände bzw. Zustandsänderungen in der Meßvorrichtung gemäß Fig. 1,

Fig. 9 bis 12  die Signalzustände bzw. Zustandsänderungen in der Meßvorrichtung gemäß Fig. 1 für den Grenzfall $\Psi_2(t)=0$,

Fig. 13        schematisch den Aufbau einer Meßvorrichtung zur Durchführung des modifizierten $\Delta\Psi$-Grundmeßverfahrens,

Fig. 14 bis 20 die Signalzustände bzw. Zustandsänderungen in der Meßvorrichtung gemäß Fig. 13,

Fig. 21        den schematischen Aufbau einer Meßvorrichtung zur Durchführung eines ersten Zusatzverfahrens,

Fig. 22        den schematischen Aufbau einer Meßvorrichtung zur Durchführung eines zweiten Zusatzmeßverfahrens,

Fig. 23        eine schaltungsmäßige Variante von Fig. 22 und

Fig. 24 bis 26 Meßeinrichtungen zum Stand der Technik.

Gemäß den in Fig. 1 in Form eines Aufbaus einer Meßvorrichtung hardwaremäßig dargestellten Verfahrensschritten werden bei dem $\Delta\varphi$ -Grundmeßverfahren die Drehwinkel $\varphi_1$ und $\varphi_2$ mittels zweier inkrementaler Drehgeber 3 und 4 gemessen und quantisiert. Dabei wird vorausgesetzt, daß die beiden Rotationskörper 1 und 2 ausreichende träge Massen aufweisen, die keine sprunghaften Änderungen der Drehwinkelgeschwindigkeit und damit des Differenzdrehwinkels $\Delta\varphi$ zulassen. Die Unterteilung der Drehwinkel $\varphi_1$ und $\varphi_2$ in einzelne Winkelschritte 27 ist dabei abhängig von der vorhandenen Anzahl N der Inkremente auf den Codier- bzw. Impulsscheiben der beiden inkrementalen Drehgeber 3 und 4, wobei ein einzelner Winkelschritt 27 von Inkrement zu Inkrement $\varphi_Q = \frac{360}{N}$ ist. Von jedem inkrementalen Drehgeber 3 bzw. 4 wird pro Winkelschritt 27 ein Impuls erzeugt.

Dem inkrementalen Drehgeber 4 ist ein Zähler 5 und dem inkrementalen Drehgeber 3 ein Zähler 6 nachgeschaltet. Als Zähler 5 und 6 können entweder zwei auf digitaler Basis arbeitende Vorwärtszähler, zwei Rückwärtszähler oder stattdessen je ein Vorwärts- und ein Rückwärtszähler verwendet werden. Während der Rotation der beiden Rotationskörper 1 und 2 werden die beiden von den inkrementalen Drehgebern 3 und 4 erzeugten Impulsfolgen in den beiden Zählern 5 und 6 gezählt, die in dem in Fig. 1 dargestellten Grundverfahren beispielhaft als Vorwärts-Digitalzähler 5 und Rückwärts-Digitalzähler 6 mit jeweils 4 Bit ausgebildet sind und somit eine Zählkapazität von 1 bis 16 aufweisen. Da die Impulsfolgen jedoch eine wesentlich höhere Zahl liefern, läuft der Vorwärts-Digitalzähler 5 beim Erreichen der Zahl 16 über, beginnt wieder bei der Zahl 1, zählt weiter bis zur Zahl 16 usw.. Der Rückwärts-Digitalzähler 6 verhält sich in entsprechender Weise. Wenn bei der Messung nicht der Drehwinkel $\varphi$, sondern der Differenzdrehwinkel $\Delta\varphi$ gesucht wird, spielt das Überlaufen der Zähler 5 und 6 keine Rolle.

Die beiden Digitalzähler 5 und 6 sind mit einem gemeinsamen Differenzbilder 7 verbunden, der in Abhängigkeit von der Art der verwendeten Rechner als digitaler Addierer oder digitaler Subtrahierer ausgebildet sein kann. Der beim $\Delta\varphi$-Grundmeßverfahren eingesetzte digitale Addierer 7 bildet nun mittels Addition der Zählerstände der beiden Digitalzähler 5 und 6 die Differenz zwischen den einlaufenden Impulsen, wobei die Zahl am Ausgang des digitalen Addierers 7 den Ausgang ohne Überlauf-Bit darstellt. Der maximal meßbare Differenzdreh-

winkel $\Delta\varphi$ max wird durch die Kapazität der Digitalzähler 5 und 6 sowie des digitalen Addierers 7 begrenzt. Beim alternativen Einsatz von jeweils zwei Vorwärts-oder zwei Rückwärtszählern ist der Differenzbilder 7 als digitaler Subtrahierer ausgebildet, der die Differenzbildung der beiden Zählerstände mittels digitaler Subtraktion durchführt.

Der Ausgang des digitalen Addierers 7 ist mit einem Digital/Analog-Konverter verbunden, dem ein Tiefpaßfilter 9 nachgeschaltet ist. Das Tiefpaßfilter 9 ist mit einer nachgeordneten Anzeigevorrichtung 10 gekoppelt.

Anhand der Figuren 2 bis 8 können die auftretenden Signale des $\Delta\varphi$ -Grundmeßverfahrens verfolgt werden. In den Figuren 2 und 3 sind die Drehwinkel $\varphi_2$ und $\varphi_1$ als Funktion der Zeit t quantisiert in einzelne Winkelschritte $\varphi_Q$ (Quantisierungsstufe 27) dargestellt. Das Diagramm der Fig. 2 zeigt die tatsächlich durch die Ungleichmäßigkeit des Antriebes, z.B. infolge Verzahnungsfehlern vorkommenden physikalischen Größen auf, wobei die Nichtlinearität der Drehwinkelkurve durch teilweises Voreilen und teilweises Nacheilen des Drehwinkels $\varphi_2$ bedingt ist. Aufgrunddessen variieren die Zeitspannen zwischen den einzelnen Quantisierungsstufen 27. Beim Diagramm der Fig. 3 mit linear ansteigendem Kurvenverlauf des Drehwinkels $\varphi_1$ wurde angenommen, daß der Antrieb gleichförmig ist und der Drehwinkel $\varphi_1$ linear mit der Zeit t zunimmt. Dadurch bleiben die Zeitspannen zwischen den einzelnen Quantisierungsstufen 27 jeweils konstant.

In den Figuren 4 und 5 sind die von den inkrementalen Drehgebern 3 und 4 ausgegebenen Impulse bzw. Impulsfolgen, ausgedrückt in Spannungswerten $U_2$ und $U_1$, als Funktion der Zeit t dargestellt. In Abhängigkeit von der Nichtlinearität des Drehwinkels $\varphi_2$ ergibt sich beim Impulsdiagramm der Fig. 4 eine zeitliche Unregelmäßigkeit der Impulsfolge, währenddessen beim Impulsdiagramm der Fig. 5 gemäß der Linearität des Drehwinkels $\varphi_1$ die Zeitspanne zwischen den einzelnen Impulsen unverändert bleibt.

In Fig. 6 sind symbolisch die Zählerstände der beiden Digitalzähler 5 und 6 real in Digitalzahlen dargestellt. Während die obere Zahlenfolge der Fig. 6 den Zählerstand des Vorwärts-Digitalzählers 5 veranschaulicht, zeigt die untere den des Rückwärts-Digitalzählers 6 auf. Da die Digitalzähler 5 und 6, wie bereits

zuvor erläutert, in der Meßvorrichtung zur Durchführung des $\Delta\varphi$ -Grundmeß-verfahrens gemäß Fig. 1 beispielhaft als 4 Bit-Zähler ausgebildet sind, laufen diese beim Erreichen der Zahl 16 über und beginnen wieder bei der Zahl 1 von neuem zu zählen.

Im Stufendiagramm der Fig. 7 ist der digitale Zahlenwert veranschaulicht, welcher sich aus der digitalen Addition der Zählerstände der beiden Digitalzähler 5 und 6 ohne Überlauf-Bit ergibt und folglich am Ausgang des digitalen Addierers 7 anliegt. Dabei sind jedem der an der Ordinate aufgetragenen Zahlenwerte jeweils bestimmte Spannungswerte zugeordnet. Bei der Zahl 1 des Vorwärts-Digitalzählers 5 führt der Ausgang des digitalen Addierers 7 den digitalen Zahlenwert 1, der solange anhält, bis die Zahl -1 des Rückwärts-Digitalzählers 6 digital addiert wird. In diesem Moment sinkt der Zahlenwert am Ausgang des Digitaladdierers 7 auf den Wert 0, der wiederum solange anhält, bis die Zahl 2 des Digital-Vorwärtszählers 5 addiert wird. Am Ausgang des Addierers liegt nun eine 1 an, bis wiederum die -2 des digitalen Rückwärtszählers 6 addiert wird, usw..

In Fig. 8 sind sowohl die Ausgangssignale des Digital/Analog-Konverters 8 als auch die Ausgangssignale des diesem nachgeordneten Tiefpaßfilters 9, beide als Spannungswerte U, in Abhängigkeit von der Zeit t veranschaulicht. Die Ausgangssignale des Digital/Analog-Konverters 8 entsprechen wertmäßig dem Stufendiagramm gemäß Fig. 7, jedoch mit dem Unterschied, daß dessen Zahlenwerte nur in Spannungsstufen umgesetzt sind. Das Analogsignal am Ausgang des Digital/Analog-Konverters 8 springt entsprechend der anliegenden Impulsdifferenzzahl am Ausgang des digitalen Addierers 7. Die Information über den Differenzdrehwinkel $\Delta\varphi$ steckt nun für jede Quantisierung der Bezugsimpuls-folge im Tastverhältnis $\dfrac{u}{y} = \dfrac{v}{z}$ und in der Spannungsstufe des Ausgangssignales des Digital/Analog-Konverters 8. Da sich der Differenzdrehwinkel $\Delta\varphi$, wie bereits erwähnt, durch die trägen Massen der beiden Rotationskörper 1 und 2 nicht sprunghaft ändert, kann aus den einzelnen Werten ein kontinuierlicher Verlauf des Differenzdrehwinkels $\Delta\varphi$ erzeugt werden.

Die im Tastverhältnis und in den Spannungsstufen in codierter Form enthaltenen einzelnen Werte des Differenzdrehwinkels $\Delta\varphi$ werden im Tiefpaßfilter 9 durch Dekodierung zu einem kontinuierlichen, analogen Signal des Differenzdreh-

winkels $\Delta\varphi$ umgeformt, welches in Fig. 8 als sinusförmige Spannungskurve 11 dargestellt ist. Durch diese Dekodierung wird eine Auflösung des Differenzdrehwinkels $\Delta\varphi$ erreicht, die viel feiner ist als eine Quantisierungsstufe 27 der inkrementalen Drehgeber 3 und 4.

Wird nun die maximal regulär zählbare Impulsdifferenz nach einer Richtung überschritten, so ist zur Bestimmung der tatsächlich akkumulierten Impulsdifferenz sowohl die Richtung als auch die Anzahl der Überläufe in den beiden Digitalzählern 5 und 6 zu berücksichtigen.

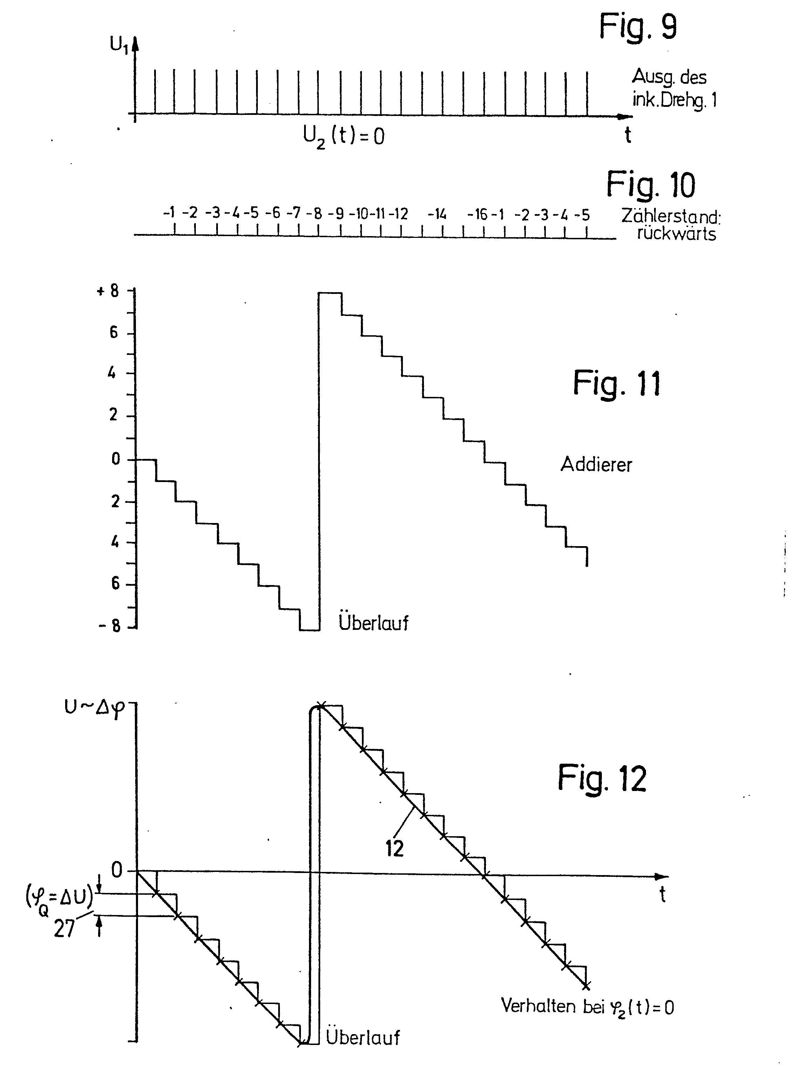

In den vier Diagrammen der Figuren 9 bis 12 ist beispielhaft der Grenzfall für $\varphi_2(t) = 0$ aufgezeigt, wobei nun der inkrementale Drehgeber 3 eine Impulsfolge mit jeweils gleichen Zeitabständen zwischen den einzelnen Impulsen gemäß Fig. 9 erzeugt. Selbstverständlich tritt in diesem Fall nur der Rückwärts-Digitalzähler 6 in Aktion und zwar genauso wie zuvor bereits beschrieben und im Diagramm der Fig. 10 dargestellt.

Da nur der Rückwärts-Digitalzähler 6 arbeitet, der Digital-Vorwärtszähler 5 jedoch still steht, ergibt sich bei der nachfolgenden digitalen Addition ausschließlich der am Rückwärts-Digitalzähler 6 vorherrschende Zahlenwert, der somit auch am Ausgang des digitalen Addierers 7 ansteht. Da die Impulsdifferenz 0 in bekannter Weise (Binary offset code) auf die Mitte der Zählerkapazität gesetzt wird, um Messungen nach beiden Richtungen, also in den Plus- und Minusbereich, erfassen zu können, baut sich dieser Zahlenwert bis zur Zahl -8 auf. Bei -8 findet ein Überlauf statt und die Addition beginnt von neuem (Fig. 11).

Der digitale Zahlenwert am Ausgang des digitalen Addierers 3 wird in ein dem Differenzdrehwinkel $\Delta\varphi$ analoges Spannungssignal U umgewandelt, welches in der nachfolgenden Fig. 12 veranschaulicht ist. Die analogen Spannungswerte springen von Quantisierungsstufe zu Quantisierungsstufe am Addiererausgang entsprechend der anliegenden Impulsdifferenzzahl. Das dekodierte und gemittelte Ausgangssignal des Tiefpaßfilters 9 bei einem Verhalten $\varphi_2(t) = 0$ ist in der Fig. 12 zusammenhängend dargestellt mit der Bezugsziffer 12 gekennzeichnet.

Mit dieser Variante des $\Delta\varphi$-Grundmeßverfahrens ist es möglich, den Differenzdrehwinkel $\Delta\varphi$ erheblich feiner als eine Quantisierungsstufe 27 aufzulösen. Trotzdem kann $\Delta\varphi$ bei dieser Auflösung über mehrere Quantisierungsstufen 27 hinweg mit absolut gleicher Genauigkeit gemessen werden. Die Genauigkeit ist unabhängig von der Höhe der Impulsfolgefrequenz. Selbst bei unzulässigen niedrigen Frequenzen, welche beispielsweise durch falsche Abstimmung des Tiefpaßfilters 9 hervorgerufen werden können, arbeitet das Verfahren im denkbar ungünstigsten Fall immer noch mit der Genauigkeit der Quantisierung der als Stand der Technik bekannten Verfahren, d.h. das Signal wird in diesem Fall praktisch nicht geglättet. Das Vorzeichen des Differenzdrehwinkels ist durch das Vorzeichen des gefilterten Analogsignales gegeben.

Bei Schwankungen des Differenzdrehwinkels $\Delta\varphi$ innerhalb eines festen, bekannten Bereiches und/oder bei hohen Impulsfrequenzen kommt ein modifiziertes $\Delta\varphi$-Grundmeßverfahren zur Anwendung, das eine Problemlösung mit einfachen und billigen Bausteinen ermöglicht, ohne dabei an Genauigkeit einzubüßen.

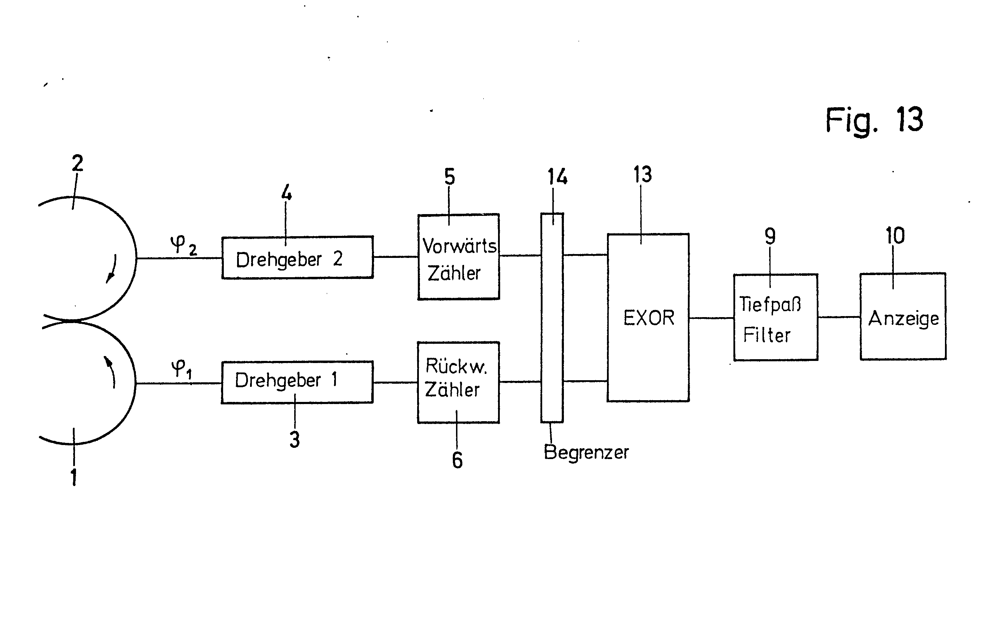

In Fig. 13, ist die Schaltung zur Durchführung dieses modifizierten $\Delta\varphi$-Grundmeßverfahrens dargestellt, deren Aufbau im wesentlichen der Meßvorrichtung des $\Delta\varphi$-Grundmeßverfahrens gemäß Fig. 1 gleicht, mit Ausnahme einer Modifikation. Diese besteht darin, daß der digitale Addierer 7 sowie der Digital/Analog-Konverter 8 des $\Delta\varphi$-Grundmeßverfahrens gemeinsam in einem Exklusiv-ODER-Gatter 13, kurz Exor genannt, realisiert sind, dem ein Begrenzer 14 vorgeschaltet ist. Die digitale Addition der Zahlenwerte der beiden Digitalzähler 5 und 6 sowie die Digital/Analog-Umwandlung des digitalen Additionsergebnisses werden gleichzeitig in dem Exor 13 vorgenommen. Wie beim $\Delta\varphi$-Grundmeßverfahren bilden das Tiefpaßfilter 9 sowie die diesem nachgeschaltete Anzeigevorrichtung 10 den Abschluß der Meßvorrichtung.

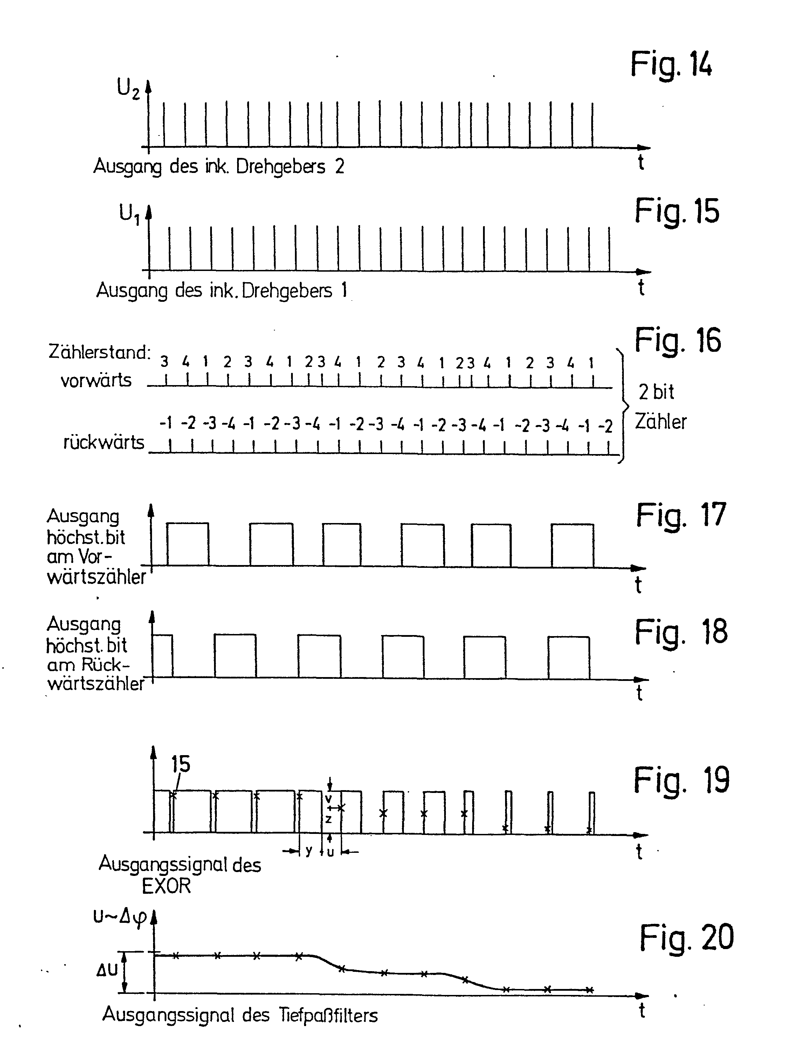

Anhand der Figuren 14 bis 20 ist die Wirkungsweise des modifizierten $\Delta\varphi$-Grundmeßverfahrens nachfolgend im einzelnen beschrieben.

Nach der Quantisierung der Winkel $\varphi_1$ und $\varphi_2$ werden die in den Figuren 14 und 15 dargestellten Impulsfolgen der inkrementalen Drehgeber 3 und 4 in der bereits zuvor beschriebenen Art des $\Delta\varphi$-Grundmeßverfahrens auf den Vorwärts-und den Rückwärts-Digitalzähler 5 und 6 gelegt. Deren Zählerkapazität ist durch den Begrenzer 4 so groß gewählt, daß die größte darstellbare Zahl größer oder gleich der Anzahl der von $\Delta \Psi$ eingenommenen Quantisierungsstufen 27 ist.

In dem in Fig. 16 dargestellten Beispiel umfaßt $\Delta \Psi$ maximal vier Quantisierungen, so daß die Digitalzähler 5 und 6 als 2 Bit-Zähler mit einer Zählerkapazität von 4 ausgelegt sind. Im Gegensatz zum $\Delta \Psi$-Grundmeßverfahren werden nun nicht alle Bit-Stellen der Digitalzähler 5 und 6 zur Addition benutzt, sondern es wird jeweils nur der Zustand des höchsten Bit berücksichtigt. Die Digitalzähler 5 und 6 wirken somit als Frequenzteiler, da eine Zustandsänderung entsprechend der Bit-Stufen, erst nach je zwei, vier, acht usw. Impulsen auftritt.

Die beiden am Ausgang der 2 Bit-Digitalzähler 5 und 6 vorliegenden Analogsignale gemäß den Figuren 17 und 18 werden dann auf den Eingang des Exors 13 gelegt. Dessen Ausgang liefert nur dann ein bestimmtes analoges Spannungssignal, wenn der Zustand der beiden Digitalzähler 5 und 6 gleich ist, d.h. nur dann wenn beide eine Spannung haben oder stattdessen beide spannungslos sind. Ist der Zustand der beiden Digitalzähler 5 und 6 ungleich, so liegt am Ausgang des Exors 13 keine Spannung an. Demgemäß entsteht das in Fig. 19 dargestellte Stufendiagramm, wobei die Werte von $\Delta \Psi$ je zwei Quantisierungsstufen (2-Bit-Zähler) mit der Bezugsziffer 15 gekennzeichnet sind. Das Ausgangssignal des Exors 13 gemäß Fig. 19 entspricht dem eines einstufigen Addierers und eines einstufigen Digital/Analog-Konverters.

Die Information über den Differenzdrehwinkel $\Delta \Psi$ steckt in dem in Fig. 19 dargestellten und bereits zuvor bei der Abhandlung des $\Delta \Psi$-Grundmeßverfahrens näher erläuterten Tastverhältnisses des Signales $\frac{u}{y} = \frac{v}{z}$. Um eine analoge Aussage über den Differenzdrehwinkel $\Delta \Psi$ machen zu können, muß deshalb ebenfalls wie beim $\Delta \Psi$-Grundmeßverfahren eine Dekodierung des Ausgangssignales des Exors 13 mittels des Tiefpaßfilters 9 vorgenommen werden, bevor dieses zur Anzeige gebracht wird. Das dekodierte Spannungssignal 11 ist in Fig. 20 dargestellt.

Durch Vergrößerung der Zählerkapazität kann zwar bei diesem modifizierten

$\Delta\Psi$-Grundmeßverfahren die Genauigkeit etwas verringert werden, da nur das höchste Bit gezählt wird; sie ist jedoch trotzdem noch erheblich besser als bei den zum Stand der Technik bekannten Meßverfahren. Der wesentliche Vorteil dieses modifizierten $\Delta\Psi$-Grundmeßverfahrens liegt - ausgehend von den eingangs erwähnten Voraussetzungen - darin, mit einem Minimum an Kosten durch Verwendung einfacher handelsüblicher Bausteine sehr hohe Impulsfolgefrequenzen verarbeiten zu können, da die Grenzfrequenz des verwendeten Logikbausteines Exor 13 erheblich höher liegt als die des Digital/Analog-Konverters 8.

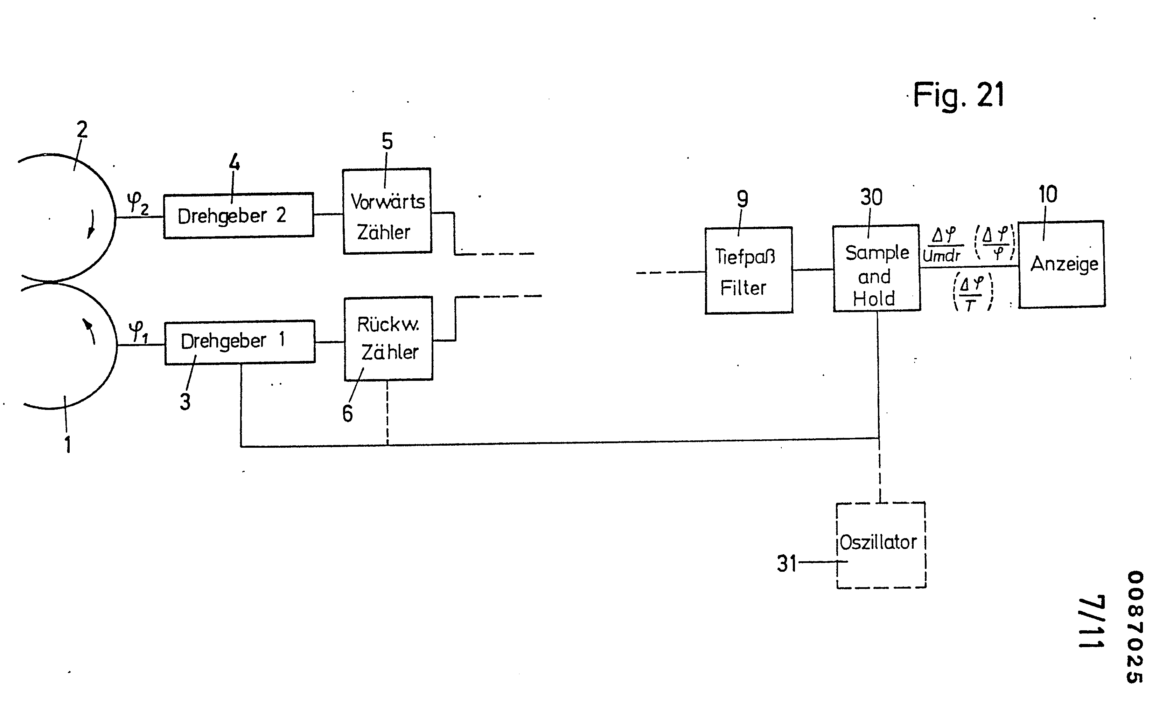

Nach der Bestimmung des Differenzdrehwinkels $\Delta\Psi$ kann eine Weiterverarbeitung des $\Delta\Psi$ proportionalen Analogsignales angebracht sein, um die Differenzwinkelgeschwindigkeit $\Delta\omega$, den pro Umdrehung pro Winkel, bzw. pro Zeiteinheit aufgelaufenen Differenzdrehwinkel $\frac{\Delta\Psi}{u}, \frac{\Delta\Psi}{\Psi}$, bzw. $\frac{\Delta\Psi}{T}$ zu ermitteln, insbesondere zur Bestimmung der Übersetzung von Antrieben. Hierzu ist ein erstes Zusatzmeßverfahren vorgesehen, das sich zur Kombination sowohl mit dem $\Delta\Psi$-Grundmeßverfahren als auch mit dem modifizierten $\Delta\Psi$-Grundmeßverfahren eignet. Der Schaltungsaufbau dieses ersten Zusatzmeßverfahrens ist in Fig. 21 dargestellt.

Wie aus dieser Figur ersichtlich, ist zwischen dem Tiefpaßfilter 9 und der Anzeigevorrichtung 10 zusätzlich ein taktgesteuertes Speicherglied 30 zwischengeschaltet, das vorzugsweise als Sample and Hold-Baustein ausgebildet ist. Die Taktsteuerung des Speichergliedes 30 kann auf dreifache Art erfolgen:

1. Durch die einmal pro Umdrehung abgegebenen Null-Impulse der inkrementalen Drehgeber 3 und 4. In diesem Fall ist der Sample and Hold 30 mit einem inkrementalen Drehgeber 3 bzw. 4 gekoppelt. Man erhält somit einen umdrehungsabhängigen Takt.

2. Die Taktung kommt von den digitalen Zählern 5 und 6. Jedesmal wenn eine binäre Zahl z.B. 2,4,16 usw. überschritten wird, sondert einer der beiden Digitalzähler 5 bzw. 6 einen Takt ab. In diesem Fall muß der Sample and Hold 30 mit Rücksetzeingängen der beiden Digitalzähler 5 und 6 rückgekoppelt sein. Man erhält dadurch einen winkelabhängigen Takt.

3.    Durch Vorgabe einer festen Frequenz als Zeittakt, erzeugt durch ein separates Zeitglied 31. In diesem Fall ist der Sample and Hold 30 mit dem separaten Zeitglied 31 gekoppelt, welches vorzugsweise als quarzgesteuerter Oszillator ausgebildet ist. Man erhält somit einen zeitabhängigen Takt.

Das erste Zusatzmeßverfahren wird nachfolgend beispielhaft an Hand der Taktung durch den inkrementalen Drehgeber 3 beschrieben, da die Taktung mittels eines der Digitalzähler 5 bzw. 6 sowie des quarzgesteuerten Oszillators 31 in Fig. 21 nur schematisch angedeutet sind. Durch die Takterzeugung mittels des inkrementalen Drehgebers 3 wird im taktgesteuerten Speicherglied 30 der pro Umdrehung der Rotationskörper 1 und 2 entstandene Differenzdrehwinkel $\frac{\Delta \Psi}{\mu}$ festgehalten, d.h. es wird die Veränderung des Differenzdrehwinkels $\Delta \Psi$ bezogen auf einen zurückgelegten Drehwinkel des Zylinders 1 gespeichert. Dem gesuchten Ergebnis entspricht also die Steigung der Funktion $\Delta \Psi(\Psi_1)$ über einen Bereich von $\Psi_1 = 360°$.

Zur Realisierung wird aus dem Rückwärts-Digitalzähler 6 nach N-Strichzahlen des inkrementalen Drehgebers 3 ein Impuls abgeleitet und dem Sample and Hold 30 zugeführt. Ebensogut kann, wie zuvor unter Punkt 2 erwähnt, der in den inkrementalen Drehgebern 3 bzw. 4 vorhandene sogenannte Null-Impuls verwendet werden, der einmal pro Umdrehung erzeugt und ebenfalls dem Sample and Hold 30 abgegeben wird. Der Sample and Hold 30 speichert den im Zeitpunkt des Impulses vorhandenen $\Delta \Psi$-Wert bis zum Eintreffen des nächsten Impulses. Da gleichzeitig jedesmal die Digitalzähler 5 und 6 wieder auf Null gesetzt werden, läuft der $\Delta \Psi$-Wert jedesmal aufs Neue vom Wert Null ab. Daher stellt das Ausgangssignal des Sample and Hold 30 direkt ein $\frac{\Delta \Psi}{\mu}$ proportionales Signal dar.

Selbstverständlich kann anstelle des Wertes $\Psi_1 = 360°$ jeder beliebige Winkelwert gewählt werden, ebenso wie anstelle des Winkels $\Psi_1$ die Zeit als Basis (quarzgesteuerte Periode T) gewählt werden kann, wobei in diesem Fall, wie unter Punkt 3 zuvor angedeutet, das Signal dann $\frac{\Delta \Psi}{\varphi} = \Delta \omega$ proportional ist.

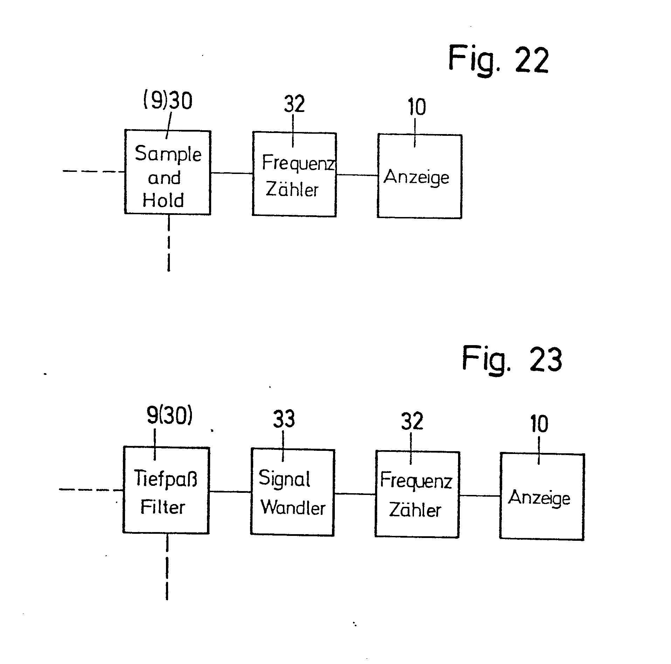

Ein zweites Zusatzmeßverfahren, dessen Verfahrenschritte sich zur Kombination mit allen zuvor erwähnten Meßverfahren und deren Abwandlungen eignet, sieht gemäß den Figuren 22 und 23 vor, daß das gefilterte, zur Anzeige vorgesehene, $\Delta\varphi$ proportionale Analogsignal zur Frequenzbestimmung herangezogen wird, so daß auch die der Differenzwinkelgeschwindigkeit $\Delta\dot{\varphi}$ = $\Delta\omega$ proportionale Differenzfrequenz der Impulsfolgen ermittelt werden kann. Dies erscheint immer dann sinnvoll, wenn die Richtung der Differenzwinkelgeschwindigkeit $\Delta\omega$ systembedingt vorgegeben ist.

Wie in Fig. 22 dargestellt, kann die Realisierung dieses Zusatzmeßverfahrens zur Frequenzbestimmung derart erfolgen, daß der Anzeigevorrichtung 10 direkt ein Frequenzzähler 32 vorgeschaltet ist, auf den das $\Delta\varphi$ proportionale Analogsignal gelegt wird. Dieser zählt jeweils bei Überschreiten eines bestimmten Spannungspegels, wodurch die Überlauffrequenz pro Zeiteinheit festgehalten wird. Eine andere Möglichkeit besteht gemäß Fig. 23 darin, daß das $\Delta\varphi$ proportionale Analogsignal in einem Signalwandler 33, vorzugsweise einem Schmitt-Trigger in ein Rechteck-Signal umgeformt und anschließend im Frequenzzähler 32, durch Zählung der Überläufe bzw. durch Zählung der Schwellwertüberschreitungen die Überlauffrequenz pro Zeiteinheit bestimmt wird.

Das neue $\Delta\varphi$ -Meßverfahren kann nicht nur zur Bestimmung der Übersetzung einzelner Antriebmechanismen, sondern in vorteilhafter Weise auch zu Messungen in anderen technischen Bereichen verwendet werden. Insbesondere dann, wenn zwei nahezu gleich schnelle Bewegungen rotativer und/oder translativer Art quantisiert werden und die Lage bzw. die Veränderung der Lage der Quantisierungen zueinander gesucht ist, wird dieses Verfahren von besonderem Interesse sein.

Zur Kontrolle der Verzahnungsqualität wird heute vielfach die Einflankenwälzprüfung benutzt. Mit den heutigen Verfahren ist dies nur bei extrem langsamer Drehzahl möglich. Außerdem wird hierfür eine komplexe Rechnerschaltung benötigt. Mit dem neuen Verfahren kann die Lage der Zahnräder zueinander und damit die Momentanübersetzung im gesamten Drehzahlbereich untersucht werden. Die Meßeinrichtung ist trotz besserer Auflösung einfacher und billiger. Eine Gesamtkontrolle der in der Maschine eingebauten Verzahnung rückt daher in den Rahmen wirtschaftlicher Möglichkeiten. Für diese Anwendung können neben dem $\Delta\varphi$-Grundmeßverfahren sehr gut auch die Zusatzmeßverfahren benutzt werden.

Zusätzliche Anwendungsgebiete eröffnen sich, wenn die Drehwinkeländerung bezogen auf einen zurückgelegten Drehwinkel $\frac{\Delta \varphi}{\varphi}$ gesucht ist. Bei Reibradgetrieben bzw. Schmitzringen in Offsetdruckmaschinen wird auch die vorgegebene Übersetzung i = 1, d.h. gleichgroße Durchmesser, bedingt durch die Fertigungstoleranz nicht exakt erreicht. Zur Bestimmung der tatsächlichen Übersetzung muß die Differenz der aufeinander abrollenden Umfänge ermittelt werden. Da diese Abweichung, bezogen auf eine Umdrehung $< |10^{-4}|$ ist, ist eine schnelle zuverlässige Messung erst durch das neue, innerhalb einer Quantisierung auflösende $\Delta \varphi$-Meßverfahren möglich. Da außerdem festgestellt werden kann, ob durch die Fertigungstoleranz eine Reibradübersetzung ins Schnelle oder ins Langsame entstanden ist, wird eine bisher nicht erreichbare, qualitätsfördernde Auslese der Reibradgetriebe für den Einbau in die Maschine möglich.

Eine weitere Anwendung bezüglich Winkeländerung pro Winkel ergibt sich bei der Messung der Elastitzitätskonstanten einer laufenden Papierbahn. Hierzu sind wie beim Zugversuch zwei Zustände unterschiedlicher Spannung notwendig. Neben der Spannungsdifferenz $\Delta \sigma$ muß die zwischen beiden Zuständen entstandene Dehnung $\varepsilon = \frac{\Delta \ell}{\ell}$ gemessen werden. Entsprechend muß in der Papierbahn das Verhältnis $\frac{\Delta v}{v}$ gemessen werden . Durch Elimination der Zeit kann $\frac{\Delta v}{v}$ in $\frac{\Delta \varphi}{\varphi}$ umgewandelt werden. Dieser Wert kann mit dem neuen $\Delta \varphi$-Meßverfahren bestimmt werden. In dem speziellen Fall der E-Modul-Messung haben alle bisherigen Verfahren versagt, da die Differenzgeschwindigkeit um einen Faktor $10^{-4}$ kleiner ist als die Bezugsbahngeschwindigkeit, die Differenzgeschwindigkeit jedoch trotzdem mit einer Genauigkeit von 4 Stellen bestimmt werden muß. Erst die direkte Messung des Differenzdrehwinkels $\Delta \varphi$ ermöglicht diese Genauigkeit.

Zur Erzielung des Gleichlaufs zweier Motoren bzw. zwischen zwei von je einem Motor angetriebenen Rotoren ist zur Regelung die momentane Abweichung von der Phase, d.h. der Differenzwinkel als Information erforderlich. Mit den bisherigen Verfahren ist ein Gleichlauffehler von ± einer Quantisierung des Winkels erreicht worden. Da mit dem neuen Verfahren der Differenzwinkel praktisch in Echtzeit mit fast absoluter Genauigkeit gemessen werden kann, ist jede Änderung der Winkellage nicht nur in ihrer Größe, sondern auch in ihrer Tendenz meßbar.

Sollen z.B. zwei Druckwerke über eine elektrische Welle verbunden werden, so muß der dazu gehörende Motorregelkreis zur Erfüllung des drucktechnisch notwendigen Gleichlaufes die beiden Druckwerke so extrem phasenstarr antreiben, wie dies mit den bisherigen Verfahren nicht möglich ist. Dazu ist eine höchstgenaue Aussage über die Lage und die Änderung der Phase bzw. des Differenzdrehwinkels $\Delta \varphi$ unabhängig von der Drehzahl notwendig. Diese Aufgabe kann durch das neue $\Delta \varphi$-Meßverfahren in einfacher Weise gelöst werden.

Selbstverständlich ist die Anmeldung nicht auf die in der Beschreibung niedergelegten und in den Figuren dargestellten Meßverfahren, Meßvorrichtungen und insbesondere auf die erwähnten Anwendungsgebiete beschränkt, die lediglich als die Erfindung nicht begrenzende Beispiele anzusehen sind. Es versteht sich von selbst, daß die gegebene Offenbarung beliebige Kombinationen und Erweiterungen der Meßverfahren zuläßt ebenso wie deren Verwendung zu Meß-und Prüfzwecken in anderen technischen Sachgebieten. Außerdem sind zahlreiche schaltungsmäßige Abwandlungen und Varianten im Aufbau der Meßvorrichtungen denkbar, wobei auch der Austausch und die Anwendung äquivalenter elektronischer bzw. digitaler Schaltungsbausteine im Rahmen der Erfindung liegen.

## TEILELISTE

1 Rotationskörper

2 Rotationskörper

3 inkrementaler Drehgeber

4 inkrementaler Drehgeber

5 Vorwärtszähler (Digitalzähler)

6 Rückwärtszähler (Digitalzähler)

7 Differenzbilder (digitaler Addierer)

8 Digital/Analog-Konverter

9 Tiefpaßfilter

10 Anzeigevorrichtung

11 Spannungskurve

12 gefiltertes Ausgangssignal für $\varphi_2(t) = 0$

13 Exklusiv-ODER-Gatter (Exor)

14 Begrenzer

15 $\Delta\varphi$ Werte pro zwei Quantisierungsstufen

16

17

18

19

20 Vorzähler-Meßeinheit

21 Überlaufzähler-Meßeinheit

22 Analog-Komparator

23 Bit-Inverterer

24 Analog-Addierer

25 Kurvenhälfte $\varphi_1(t) = 0$

26 Kurvenhälfte $\varphi_2(t) = 0$

27 Quantisierungsstufe $\varphi_Q$ (Winkelschritt)

28 Inversionssprung

29 Inversionssprung

30 taktgesteuertes Speicherglied (Sample and Hold)

31 separates Zeitglied (quarzgesteuerter Oszillator)

32 Frequenzzähler

33 Signalwandler (Schmitt-Trigger)

- 1 -

## PATENTANSPRÜCHE

1. Verfahren zur hochgenauen Messung der Phasenlage bzw. Phasenverschiebung zweier Impulsfolgen, bei dem beispielsweise die Drehwinkel zweier Rotationskörper quantisiert, durch inkrementale Drehgeber in Impulsfolgen umgewandelt und diese zur Ermittlung der Phasenlage bzw. der Phasenverschiebung herangezogen werden,
   gekennzeichnet durch folgende Verfahrensschritte:
   1. Zählung der Impulsfolgen in zumindest zwei differenten Zählern,
   2. Digitale Differenzbildung der beiden Zählerstände und anschließende
   3. Wandlung des digitalen Differenzergebnisses in ein Analogsignal,
   4. Dekodierung des Analogsignales und
   5. Anzeige des dekodierten Analogsignales.

2. Verfahren nach einem oder mehreren der vorangehenden Ansprüche,
   gekennzeichnet durch folgende Verfahrensschritte:
   1. Begrenzung der Zählerkapazitäten entsprechend des auftretenden Phasenwinkels $\Delta \Psi$ und
   2. Digitale Differenzbildung der beiden Zählerstände des Vorzählers und/oder des Überlaufzählers mit gleichzeitiger Wandlung des digitalen Differenzergebnisses in ein Analogsignal.

3. Verfahren nach einem oder mehreren der vorangehenden Ansprüche,
   d a d u r c h   g e k e n n z e i c h n e t ,
   daß die digitale Differenzbildung durch digitale Addition der beiden Zählerstände eines Vorwärts- und eines Rückwärtszählers erfolgt.

4. Verfahren nach einem oder mehreren der vorangehenden Ansprüche,
   d a d u r c h   g e k e n n z e i c h n e t ,
   daß die digitale Differenzbildung durch digitale Subtraktion der beiden Zählerstände zweier Vorwärts- oder zweier Rückwärtszähler erfolgt.

5.  Verfahren nach einem oder mehreren der vorangehenden Ansprüche,
    **d a d u r c h  g e k e n n z e i c h n e t,**
    daß die Dekodierung des Analogsignales durch Tiefpaßfilterung erfolgt.

6.  Verfahren nach einem oder mehreren der vorangehenden Ansprüche,
    **gekennzeichnet durch folgende Verfahrensschritte:**
    1. Erzeugung eines Abtastintervalles
    2. Vorgabe und Speicherung des Abtastintervalles
    3. Null-Setzung des Phasenwinkels zu Beginn des Abtastintervalles
    4. Speicherung des während des Abtastintervalles aufgelaufenen Phasenwinkels
    5. Erneute Null-Setzung des Phasenwinkels nach Ablauf des Abtastintervalles
    6. Anzeige des gespeicherten Phasenwinkels $\Delta\varphi$ pro Abtastintervall.

7.  Verfahren nach einem oder mehreren der vorangehenden Ansprüche,
    **d a d u r c h  g e k e n n z e i c h n e t,**
    daß das Abtastintervall umdrehungs-, winkel-oder zeitbezogen ist.

8.  Verfahren nach einem oder mehreren der vorangehenden Ansprüche,
    **gekennzeichnet durch folgende Verfahrensschritte:**
    1. Abtasten und Speichern des zur Anzeige vorgesehenen, dem Differenz-
       drehwinkel $\Delta\varphi$ proportionalen Analogsignales,
    2. Erzeugung eines Zeitintervalles durch ein separates Zeitglied,
    3. Division durch das Zeitintervall zwischen den Abtastungen und
    4. Ausgabe eines der Differenzwinkelgeschwindigkeit $\Delta\dot\varphi$ proportionalen
       Analogsignales.

9.  Verfahren nach einem oder mehreren der vorangehenden Ansprüche,
    **gekennzeichnet durch folgende Verfahrensschritte:**
    1. Abtasten und Speichern des zur Anzeige vorgesehenen, dem Differenz-
       drehwinkel $\Delta\varphi$ proportionalen Analogsignales,
    2. Erzeugung eines Zeitintervalles durch zumindest einen inkrementalen
       Drehgeber oder einen Zähler
    3. Division durch den Winkelbereich zwischen den Abtastungen und
    4. Ausgabe eines dem Differenzdrehwinkel pro Winkel $\frac{\Delta\varphi}{\varphi}$ oder pro
       Umdrehung $\frac{\Delta\varphi}{u}$ proportionalen Analogsignales.

10. Verfahren nach einem oder mehreren der vorangehenden Ansprüche,

    d a d u r c h   g e k e n n z e i c h n e t,

    daß das zur Anzeige vorgesehene dem Differenzdrehwinkel $\Delta\Psi$ proportionale Analogsignal zur Frequenzbestimmung herangezogen wird.

11. Verfahren nach einem oder mehreren der vorangehenden Ansprüche,

    d a d u r c h   g e k e n n z e i c h n e t,

    daß die Frequenzbestimmung durch Zählen der Überläufe bzw. der Überlauffrequenz pro Zeiteinheit in einem Frequenzzähler erfolgt.

12. Verfahren nach einem oder mehreren der vorangehenden Ansprüche,

    d a d u r c h   g e k e n n z e i c h n e t,

    daß vor der Frequenzbestimmung das zur Anzeige vorgesehene, dem Differenzdrehwinkel $\Delta\Psi$ proportionale Analogsignal in ein Rechtecksignal umgewandelt wird.

13. Vorrichtung zur Durchführung des Verfahrens nach Anspruch 1, mit zwei Rotationskörpern, an denen jeweils ein inkrementaler Drehgeber angeordnet ist,

    d a d u r c h   g e k e n n z e i c h n e t,

    daß jedem der beiden inkrementalen Drehgeber (3 und 4) jeweils ein Zähler (5 bzw. 6) nachgeschaltet ist, die beide mit einem gemeinsamen Differenzbilder (7) verbunden sind, dem in Reihe ein Digital/Analog-Konverter (8) sowie ein Tiefpaßfilter (9) nachgeordnet sind, wobei letzteres mit einer Anzeigevorrichtung (10) gekoppelt ist.

14. Vorrichtung nach einem oder mehreren der vorangehenden Ansprüche,

    d a d u r c h   g e k e n n z e i c h n e t,

    daß die beiden Zähler (5 und 6) als ein Vorwärts- und Rückwärtsdigitalzähler und der Differenzbilder (7) als digitaler Addierer ausgebildet sind.

15. Vorrichtung nach einem oder mehreren der vorangehenden Ansprüche,

    d a d u r c h   g e k e n n z e i c h n e t,

    daß beide Zähler (5 und 6) als Vorwärts- oder Rückwärtsdigitalzähler und der Differenzbilder (7) als digitaler Subtrahierer ausgebildet sind.

16. Vorrichtung nach einem oder mehreren der vorangehenden Ansprüche ,
d a d u r c h  g e k e n n z e i c h n e t,
daß der digitale Differenzbilder (7) sowie der Digital/Analog-Konverter (8) gemeinsam in einem Exklusiv-ODER Gatter (13) realisiert sind und diesem ein Begrenzer (14) vorgeschaltet ist.

17. Vorrichtung nach einem oder mehreren der vorangehenden Ansprüche,
d a d u r c h  g e k e n n z e i c h n e t,
daß zwischen dem Tiefpaßfilter (9) und der Anzeigevorrichtung (10) ein taktgesteuertes Speicherglied (30) zwischengeschaltet ist.

18. Vorrichtung nach einem oder mehreren der vorangehenden Ansprüche,
d a d u r c h  g e k e n n z e i c h n e t,
daß das taktgesteuerte Speicherglied (30) zur Taktsteuerung zumindest mit einem der beiden inkrementalen Drehgeber (3 bzw. 4), einem der beiden Zähler (5 bzw. 6) oder einem separaten Zeitglied (31) gekoppelt ist.

19. Vorrichtung nach einem oder mehreren der vorangehenden Ansprüche
d a d u r c h  g e k e n n z e i c h n e t,
daß das taktgesteuerte Speicherglied (30) als Sample and Hold ausgebildet ist.

20. Vorrichtung nach einem oder mehreren der vorangehenden Ansprüche,
d a d u r c h  g e k e n n z e i c h n e t,
daß vor der Anzeigevorrichtung (10) ein Frequenzzähler (32) angeordnet ist.

21. Vorrichtung nach einem oder mehreren der vorangehenden Ansprüche,
d a d u r c h  g e k e n n z e i c h n e t,
daß dem Frequenzzähler (32) ein Signalwandler (33) vorgeschaltet ist.

22. Vorrichtung nach einem oder mehreren der vorangehenden Ansprüche,
d a d u r c h  g e k e n n z e i c h n e t,
daß der Signalwandler (33) als Schmitt-Trigger ausgebildet ist.

23. Verwendung eines Verfahrens zur hochgenauen Messung der Phasenlage bzw. Phasenverschiebung zweier Impulsfolgen zur Einflankenwälzprüfung bei Zahnrädern.

24. Verwendung eines Verfahrens zur hochgenauen Messung der Phasenlage bzw. Phasenverschiebung zweier Impulsfolgen zur Ermittlung der Übersetzung von reibschlüssigen Getrieben, insbesondere Schmitzringantrieben in Offset-Druckmaschinen.

25. Verwendung eines Verfahrens zur hochgenauen Messung der Phasenlage bzw. Phasenverschiebung zweier Impulsfolgen zur Messung des E-Moduls einer laufenden Papierbahn.

26. Verwendung eines Verfahrens zur hochgenauen Messung der Phasenlage bzw. Phasenverschiebung zweier Impulsfolgen zur Messung des Gleichlaufes zweier Druckwerke.

Fig. 1

2/11

0087025

Fig. 2

Fig. 3

Fig. 4

Ausgang des
ink. Drehgebers 2

Fig. 5

Ausgang des
·ink. Drehgebers 1

0087025

## Fig. 6

Zählerstand:

vorwärts    1 2 3 4   5 6 7 8 9  10  11 12 13 14  15    16    1 2 3 4

rückwärts   -1 -2 -3 -4 -5 -6 -7 -8 -9 -10   -12    -14    -16 -1 -2 -3 -4

4 bit
Zähler

## Fig. 7

Zahl am Ausgang des Addierers

## Fig. 8

Ausgangssignal des D/A-Konverters

Fig. 9

$U_1$

Ausg. des
ink.Drehg. 1

$U_2(t) = 0$

t

Fig. 10

-1 -2 -3 -4 -5 -6 -7 -8 -9 -10 -11 -12   -14   -16 -1 -2 -3 -4 -5   Zählerstand:
rückwärts

Fig. 11

+8
6
4
2
0
2
4
6
-8

Addierer

Überlauf

Fig. 12

$U \sim \Delta\varphi$

0

$(\varphi_Q = \Delta U)$

27

12

Überlauf

t

Verhalten bei $\varphi_2(t) = 0$

Fig. 13

φ₂ — Drehgeber 2 (4) — Vorwärts Zähler (5)

φ₁ — Drehgeber 1 (3) — Rückw. Zähler (6)

Begrenzer (14)

EXOR (13)

Tiefpaß Filter (9)

Anzeige (10)

Fig. 14

$U_2$

Ausgang des ink. Drehgebers 2

Fig. 15

$U_1$

Ausgang des ink. Drehgebers 1

Fig. 16

Zählerstand:
vorwärts

3 4 1 2 3 4 1 2 3 4 1 2 3 4 1 2 3 4 1 2 3 4 1

-1 -2 -3 -4 -1 -2 -3 -4 -1 -2 -3 -4 -1 -2 -3 -4 -1 -2 -3 -4 -1 -2

rückwärts

2 bit
Zähler

Fig. 17

Ausgang
höchst. bit
am Vorwärtszähler

Fig. 18

Ausgang
höchst. bit
am Rückwärtszähler

Fig. 19

15

v
z
y u

Ausgangssignal des
EXOR

Fig. 20

$u \sim \Delta\varphi$

$\Delta u$

Ausgangssignal des Tiefpaßfilters

# Fig. 21

Block diagram:

- 2
- 1
- $\varphi_2$ → Drehgeber 2 (4) → Vorwärts Zähler (5)
- $\varphi_1$ → Drehgeber 1 (3) → Rückw. Zähler (6)
- Tiefpaß Filter (9) → Sample and Hold (30) → Anzeige (10)
- $\frac{\Delta\varphi}{Umdr}$ $\left(\frac{\Delta\varphi}{\varphi}\right)$ $\left(\frac{\Delta\varphi}{T}\right)$
- Oszillator (31)

Fig. 22

```
(9)30              32            10
   │               │             │
┌─────────┐    ┌──────────┐   ┌─────────┐
│ Sample  │    │ Frequenz │   │         │
── │  and    │────│  Zähler  │───│ Anzeige │
│  Hold   │    │          │   │         │
└─────────┘    └──────────┘   └─────────┘
     ╎
     ╎
```

Fig. 23

```
9(30)           33            32            10
  │             │             │             │
┌────────┐  ┌─────────┐  ┌──────────┐  ┌─────────┐
│ Tiefpaß│  │ Signal  │  │ Frequenz │  │         │
──│ Filter │──│ Wandler │──│  Zähler  │──│ Anzeige │
│        │  │         │  │          │  │         │
└────────┘  └─────────┘  └──────────┘  └─────────┘
    ╎
    ╎
```

## Fig. 24

Frequensspanng.-wandler    Subtrahierer    Dividierer

$\varphi_2$ — Drehgeber 2 — $\boxed{f_2 \diagdown U_2}$ — $\boxed{U_1 - U_2}$ — $\boxed{\dfrac{U_1 - U_2}{U_1}}$ — $\dfrac{\Delta U}{U}$

$\varphi_1$ — Drehgeber 1 — $\boxed{f_1 \diagdown U_1}$

Fig. 25

Fig. 26